# EUROPEAN PATENT APPLICATION

(11) **EP 4 554 021 A1**
(43) Date of publication of application: **14.05.2025**
(21) Application number: 24212495.6
(22) Date of filing: 12.11.2024
(51) Int. Cl.: H02B 13/035, G01R 15/16, H01B 3/40, H01B 17/00, H02B 13/065, H02G 1/14, H02G 15/064

(54) **INSULATOR FOR A CABLE TERMINATION ASSEMBLY, A TERMINATION ASSEMBLY FOR A POWER CABLE COMPRISING SUCH AN INSULATOR AND A CABLE TERMINATION SYSTEM**

(30) Priority: 13.11.2023 IT 202300023988
(71) Applicant: Prysmian S.p.A., 20126 Milan (IT)
(72) Inventor: Testa, Luigi, 08800 Vilanova i la Geltrú, Barcelona (ES); Tsakonas, Panagiotis, 2627 AN Delft (NL); Iadanza, Andrea, 20100 Milano (MI) (IT); Geene, Hendrikus, 2627 AN Delft (NL)
(74) Representative: Biallo, Dario

(57) **Abstract**

Insulator (10) for a cable termination assembly comprising:
- a main body (11) of insulating material extending along a longitudinal direction X and having a cylindrically symmetrical shape with a first longitudinal end (12) and a second longitudinal end (13) opposite to each other, said main body (11) being adapted to be fitted on a power cable;
- a ring-shaped electrode (20) made of a mesh of conducting material integrated in the main body (11) at a predefined distance from the first end (12), said ring-shaped electrode (20) being configured to be connected to an external voltage detector.

## Description

### Background of the disclosure

The present disclosure relates to an insulator for a cable termination assembly particularly used in GIS (Gas Insulated Substations) terminations (e.g. metal-enclosed cable terminations) or outdoor terminations. The present disclosure refers also to a termination assembly for a power cable comprising the above insulator and to a cable termination system. The present disclosure further refers to a method for monitoring a cable termination assembly.

For the purposes of the present description, a power cable includes at least one cable core usually formed by an electrically conductive metal conductor covered by an insulation system in its turn usually covered by an outer protective jacket which is the outermost layer of the cable. The insulation system may be sequentially formed by an inner semiconducting layer, an intermediate insulating layer, and an outer semiconducting layer. The cable may further include a metallic shield between the outer protective jacket and the insulation system configured to ground the cable. For the purposes of the present disclosure, by termination assembly for power cable it is intended a device suitable to connect an electric cable to a bare conductor, i.e. an electrical conductor with no solid insulating system applied on it, contrarily to a power cable. This termination assembly comprises electrical connecting means between the power cable conductor and the bare conductor and electrical separation means between the outer surface of the cable and parts connected thereto, generally at ground potential, and the elements under tension, such as the bare conductor. A termination assembly generally comprises:
- an electric field control element, commonly named "stress member" intended to be fitted to the power cable;
- an insulator intended to be fitted to the power cable and coupled to the electric field control element so as to surround it at least partially;
(For metal enclosed terminations in GIS the insulator serves also as a barrier for the pressurized insulating gas, for example SF6, synthetic air, fluoroketone (e.g. C5-FK), fluoronitrile (e.g. C4-FN), etc. The insulator has a metallic insert embedded in it that establishes the connection between the power cable's conductor and switchgear's conductor.)

GIS terminations commonly include the termination assembly and a tubular casing adapted to be fixed to the insulator and to house the insulator. The tubular casing can be a metallic tubular casing, for example a steel tubular casing, set at ground potential during operation.

At the beginning of the assembly operations between termination assembly and power cable, an end portion of the power cable is subjected to cut and peeling procedures so as to present, one adjacent to the other, a first length of exposed electric conductor, a second length of exposed insulating layer and then the power cable with the complete insulation system.

After the preparation of the cable is performed, the electric field control element is interference fitted over the power cable at the boundary between the exposed outer semiconductive layer and the exposed insulating layer; in particular, the electric field control element can be fitted over the prepared cable either by slipping it over or by pre-expanding it on a removable carrier tube.

Then, the power cable with the electric field control element applied thereto is interference fitted into the insulator. Such an insulator is typically made of epoxy resin and includes a metallic insert configured to be electrically connected to the electric conductor of the cable.

In common GIS assembly operation, the insualator is installed into the tubular casing prior that the cable including the electric field control element is inserted into the insulator. Differently, in some applications, the assembly operation may require that firstly the insulator is installed over the cable with the electric field control element applied thereto and secondly the insulator is inserted into the tubular casing.

The metallic insert is connected to the exposed electric conductor of the cable on one side and to a bare conductor on the other side. The bare conductor is configured to be connected to electric equipments outside of the GIS termination, such as power transformer, over-head medium of high voltage lines, etc.

The space between the the tubular casing and the power cable with the stress member and the insulator may be filled with insulating gas, like for example sulfur hexafluoride or SF6 gas.

The insulating gas assures the electric insulation between the bare conductor and the electric earth connected to the tubular casing. However, it is still required to have the opportunity to monitor over time the GIS termination in order to avoid possible dangerous electric discharges.

However, the insulator and the termination assembly of the present disclosure can be manufactured with different shapes and assemblied with different processes than the ones described before depending on the application (e.g. GIS, outdoor termination, etc). WO 2014/209739 A1 descirbes a terminal connection device comprises a contiguous body disposed onto an inner conductor. The inner conductor includes a first end mateable with a power cable connector and a second end. The body comprises a multilayer structure having an inner conductive or semiconductive layer disposed over at least a portion of the power cable connector, an insulating layer and an outer conductive or semiconductive layer. The body surrounds the first end of the inner conductor and extending towards the second end of the inner conductor. The body can also include an electrically isolated section of conductive or semiconductive material. The terminal connection device can be a fully integrated structure, having a preinstalled connection interface, or the terminal connection device can be configured as an adapter which can be mounted in the field to a connection interface.

### Summary of the disclosure

The Applicant faced the technical problem of how to monitor over time the presence of voltage. It is required to ensure that the electrical cable and the electric equipment are not under voltage during, for example, maintenance periods. Thus voltage detecting and indicating system are required according, for example, to IEC 62271-213.

Moreover, GIS termination may suffer of partial discharges and consequent degradation which may lead to failures. Therefore, partial discharges need to be monitored.

The Applicant considered to achieve this monitoring by equipping the insulator with an electrode to be connected to a voltage detector, said electrode being made by a solid metallic part embedded in the insulator body. However, the Applicant observed that this solution can weaken mechanically the insulator because there can be difference in the thermal expansion rates of the metal of the capacitive sensor and the insulating material of the insulator and thus detachment can occur with thermal cycles.

This detachment can act as initiation point for cracks that propagate throught the insulating material causing the formation of voids and consequently of possible entrapped air giving rise to the formation of partial discharges when the voltage stress exceeds the dielectric strength of air, said partial discharges harming the insulator body and causing premature failure of the termination assembly.

Therefore, the Applicant considered to make the electrode with a ring-shaped body of a mesh of conducting material and to integrate it in the insulator body during the process of formation of the insulator. In this way, the insulating material of the insulator body, for example a resin, passes through the free space of the mesh realizing a deep coupling between the electrode and the insulator avoiding any mechanical discontinuity between them. The integration of the electrode in form of a mesh in the resin is more effective than the case of a solid metallic ring. Consequently, the electrode ring can be placed in a region with significant electric field and a good coupling with the high voltage conductor can be achieved, without modifying the shape of the insulator. Therefore, according to a first aspect, the present disclosure relates to an insulator for a cable termination assembly comprising:
- a main body of insulating material extending along a longitudinal direction X and having a cylindrically symmetrical shape with a first longitudinal end and a second longitudinal end opposite to each other, said main body being adapted to be fitted on a power cable;
- a ring-shaped electrode made of a mesh of conducting material integrated in the main body at a predefined distance from the first end, said ring-shaped electrode being configured to be connected to an external voltage detector.

In an embodiment, the ring-shaped electrode is provided of at least one protrusion made of conducting material and extending in a radial direction till reaching a lateral surface of the main body.

In an embodiment the ring-shaped electrode comprises a metallic mesh plate shaped as a ring.

In an embodiment the ring-shaped electrode has a folded edge proximal with respect to the first end.

In this way, it is avoided to have a tip edge proximal to the exposed cable conductor that is positioned at the first end of the insulator, which may involve the rising of a charge accumulation on the tip that may potentially cause a dangerous discharge through the insulator body.

In an embodiment the at least one protrusion has, at its free end, a threaded bush made of conducting material.

In this way, the coupling of the electrode with the insulator may be rendered more stable during the manufacturing procedure through the use of a screw fitted in the at least one threaded bush. If the screw is made of conducting material it helps the coupling of the voltage detector with the electrode by simply directly connecting such a detector with the screw.

It is underlined that if the insulator comprises more than one protrusion with bush, just one of them is intended to be connected to a voltage detector. The remaining protrusions will be used just for the mechanical coupling of the electrode to the insulator during the molding process, that is the manufacturing of the insulator with the electrode, while using respective screws made of insulating material or made of conducting material and surrounded by insulating socks. In particular, the screws made of insulating material are used to insulate electrically the metallic inserts and avoid accidental contact with persons or other conductive objects.

In an embodiment the mesh of conducting material has a cover factor comprised between 0.2 and 0.5.

For the purposes of the present disclosure, by mesh of material is intended an element having a substantially flat shape (i.e. a dimension relevantly lower than the other two dimensions) including series of repeated holes distributed in the whole or at least in great part of the element surface. An example of mesh of material is an expanded metal, which is a type of sheet metal which has been cut and stretched to form a regular pattern (often diamond-shaped).

For the purposes of the present disclosure, by cover factor it is intended a number that indicates the extent to which the area of a mesh is covered by solid material. In particular, the cover factor is the ratio between the surface area of the electrode covered by solid material and the whole surface area of the electrode.

In an embodiment the main body is made of epoxy resin.

In an embodiment the insulator comprises a metallic insert configured to be electrically connected to an electric conductor of the power cable on one side and to a bare conductor on the other side.

In a second aspect the present disclosure relates to a termination assembly for a power cable comprising:
- an electric field control element intended to be fitted to the power cable;
- an insulator according to the disclosure wherein said insulator is intended to be coupled to the electric field control element so as to surround it at least partially.

In a third aspect the present disclosure relates to a Gas Insulated Substations termination comprising:
- a termination assembly according to the above reported;
- a tubular casing adapted to be fixed to the insulator and to house the insulator;
- a bare conductor configured to be installed within the tubular casing and to be electrically connected to the electric conductor of a power cable.

In a further aspect the present disclosure relates to a cable termination system comprising:
- a power cable;
- an electric field control element fitted to the power cable;
- an insulator according to the disclosure wherein said insulator is coupled to the electric field control element so as to surround it at least partially.

In an embodiment, the cable termination system further comprises a tubular casing fixed to the insulator so as to enclose it and define a closed space, said closed space being filled with an insulating gas.

In an embodiment the ring-shaped electrode and the cable electric conductor are electrically insulated with each other thus realizing a first capacitor, and wherein a voltage detector is electrically connected to the ring-shaped electrode, the voltage detector including a second capacitor connected in series with the first capacitor.

Alternatively, the ring-shaped electrode and the cable electric conductor are electrically insulated with each other thus realizing a first capacitor, the insulator including a second capacitor connected in series to the first capacitor, and wherein a voltage detector is electrically connected to the second capacitor.

In an embodiment the voltage detector is configured to detect the presence of eletrical pulses and/or the presence of partial discharges on the cable or on the cable termination system.

For the purpose of the present description and of the claims that follow, except where otherwise indicated, all numbers expressing amounts, quantities, percentages, and so forth, are to be understood as being modified in all instances by the term "about". Also, all ranges include any combination of the maximum and minimum points disclosed and include any intermediate ranges therein, which may or may not be specifically enumerated herein.

Also, the terms "a" and "an" are employed to describe elements and components of the disclosure. This is done merely for convenience and to give a general sense of the disclosure. This description should be read to include one or at least one, and the singular also includes the plural unless it is obvious that it is meant otherwise.

As "insulating material" it is meant a material having a conductivity lower than 10⁻¹² S/m.

As "semiconductive material" it is meant a material having a conductivity comprised between 10⁻² and 100 S/m.

### Brief description of the drawings

Further characteristics will be apparent from the detailed description given hereinafter with reference to the accompanying drawings, in which:

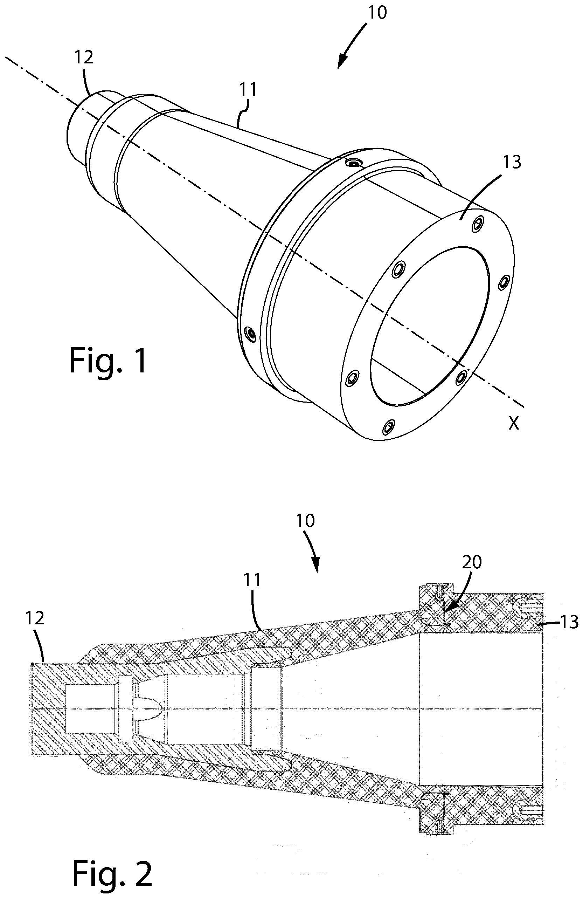

- Figure 1 is a schematic perspective view of an insulator according to the present disclosure;
- Figure 2 is a schematic cross-section of the insulator of figure 1;

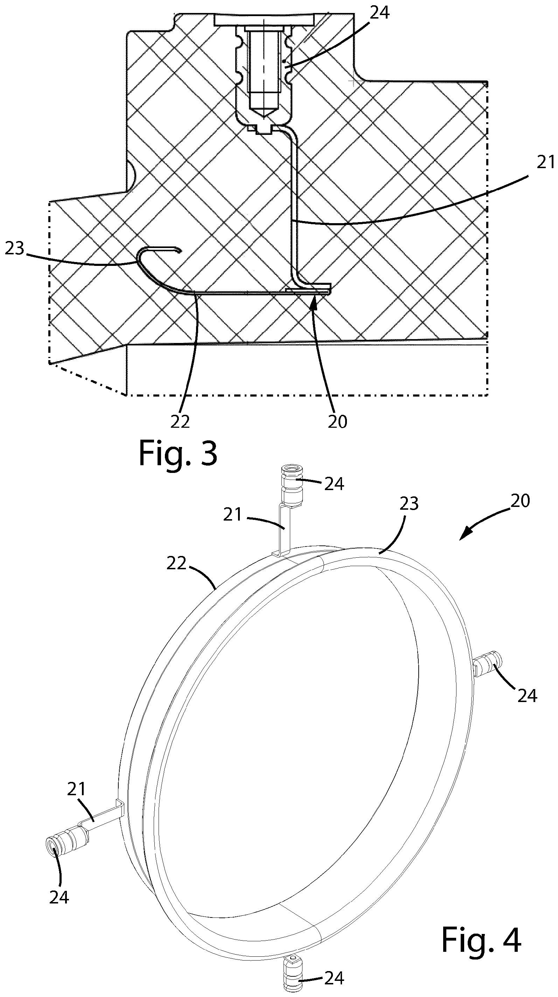

- Figure 3 is a view of a detail of figure 2;
- Figure 4 is a schematic perspective view of an electrode comprised in the insulator of figurea 1, 2A, 2B;

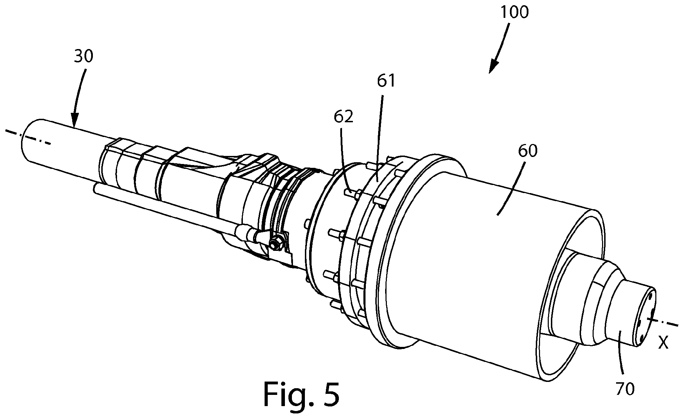

- Figure 5 is a schematic partial perspective view of a cable termination system according to the present disclosure;
- Figure 6 is a schematic partial sectioned view of a cable termination system according to an embodiment of the present disclosure;
- Figure 7 is a schematic partial sectioned view of an alternative embodiment of the present disclosure;
- Figure 8 is a schematic partial sectioned view of a further alternative embodiment of the present disclosure.

### Detailed description of some embodiments

With reference to the figures, an insulator 10 for a cable termination assembly according to the present disclosure is schematically represented.

In particular, the insulator 10 is intended to be used in a termination assembly in its turn particularly used in a Gas Insulated Substations (GIS) termination.

A power cable 30 and the GIS termination applied to such a cable make part of a cable termination system 100, according to the present disclosure.

The power cable 30 comprises at least one electric conductor 31 and a cable insulation system 32 surrounding the at least one electric conducting conductor 31. The cable insulation system 32 may comprise a cable inner semiconductive layer (not illustrated) surrounding and in contact with the electric conductor 31, a cable insulating layer (not illustrated), surrounding and in contact with the respective inner semiconductive layer, and a cable outer semiconductive layer (not illustrated), surrounding and in contact with the respective insulating layer. Around to the outer semiconductive layer an outer protective sheath 33 is provided which is considered the outermost layer of the cable. In many applications, the power cable includes a metallic shield 34 between the outer protective jacket 33 and the insulation system 32 configured to ground the cable.

The insulator 10 comprises a main body 11 of insulating material extending along a longitudinal direction X and having a cylindrically symmetrical shape with a first longitudinal end 12 and a second longitudinal end 13 opposite to each other. The main body 11 is adapted to be fitted on the power cable 30.

For example, the main body 11 may be made of a resin.

In the illustrated embodiments the first end 12 and the second end 13 have a circumferential cross-section with the cross section of the first end 12 having a diameter shorter than the diameter of the second end.

The insulator 10 comprises also a ring-shaped electrode 20 made of a mesh of conducting material integrated in the main body 11 at a predefined distance from the first end 12. In particular, the ring-shaped electrode 20 is configured to be connected to an external voltage detector 40.

The mesh of conducting materiale may have a cover factor comprised between 0.2 and 0.5.

In particular, the ring-shaped electrode 20 may be provided of at least one protrusion 21 made of conducting material.

In different embodiments the at least one protrusion 21 made of conducting material extends from the ring-shaped electrode 20 to an outer surface of the main body 11.

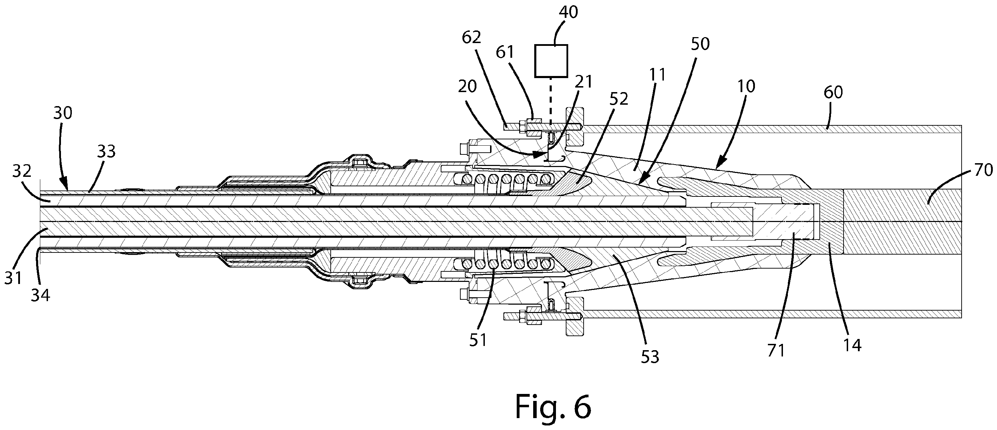

In the embodiment of figure 6 the at least one protrusion 21 extends in a radial direction till reaching a lateral surface of the main body 11.

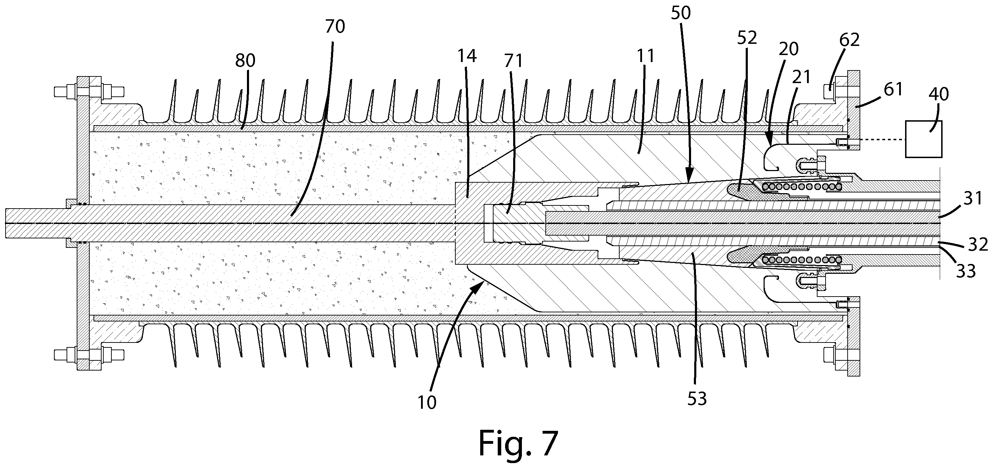

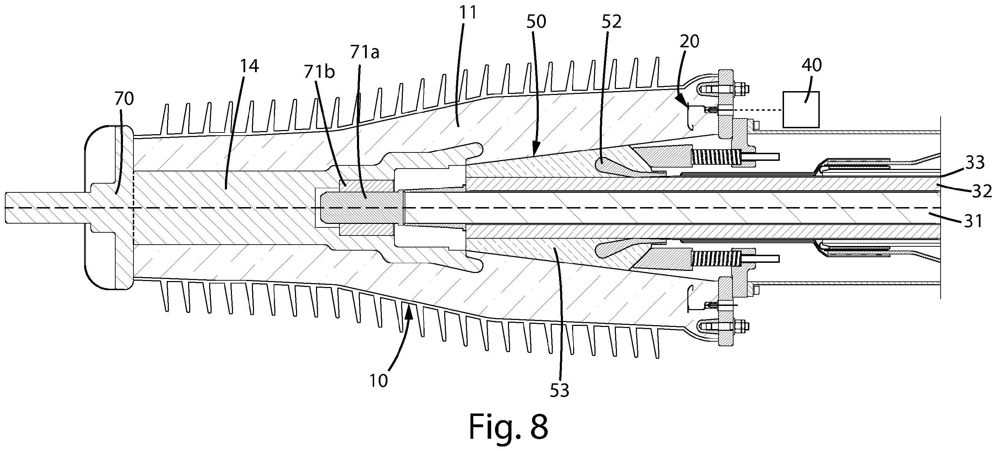

In the embodiment of figures 7 and 8 the at least one protrusion 21 extends in the longitudinal direction X till reaching the second end 13 of the main body 11. The ring-shaped electrode 20 and the cable electric conductor are electrically insulated with each other and thus realize a first capacitor the capacity of which can be estimated by computer implemented simulators or through experimental measurements.

The external voltage detector 40 may include a second capacitor connected in series with the first capacitor. In an alternative embodiment, the insulator 10 includes the second capacitor connected in series to the first capacitor, that is connected to the ring-shaped electrode 20. In this cases, the external voltage detector 40 is connected to the second capacitor.

In any case, the voltage detector 40 is configured to read the voltage across the second capacitor; therefore by knowing the voltage read by the voltage detector 40 and the estimated capacity of the first capacitor, the voltage detector 40 is capable to check the presence of voltage on the cable conductor and to estimate the voltage value for safety and operation procedure. Several different voltage detectors can be configured to be used with the cable termination assembly of the present disclosure, for example the Capacitive Voltage Detecting Systems Capdis-S2+ R4.5 manufactured by Kries-Energietechnik GmbH or the Integrated voltage detecting system Wega 1.2 C manufactured by Dipl.-Ing. H. Horstmann GmbH.

In some embodiments, the voltage detector 40 may include electronic components enabling the voltage detector 40 to detect the presence of eletrical pulses. In this embodiments the voltage detector 40 is further configured to detect the presence of partial dischargese on the cable or on the cable termination system. This is to perform condiction based maintenance.

For example, Capacitive Voltage Detecting Systems with Partial Discharge Detection CAPDIS-S2_55 (R5) manufactured by Kries-Energietechnik GmbH can be employed as voltage detector. Other examples of voltage detector capable to detect partial discharge are the partial discharge acquisition and monitoring system PryCam Grids manufactured by the applicant or the Universal partial discharge measurement and analysis system MPD 800 manufactured by Omicron, buth to be employed with a coupling quadrupole to separate low frequency signal from high frequency.

The ring-shaped electrode 20 may be made of a metal, for example copper, aluminum, stainless steel, etc.

In this case, the ring-shaped electrode 20 comprises a metallic mesh plate 22 shaped as a ring. The mesh plate 22 form assures more surface for coupling with the main body 11 since, during the formation of the main body by injection molding, the insulating material of the main body 11 penetrates and fills the holes of the mesh plate 22 of the electrode.

For example the plate may have a width comprised between 0.25 mm and 0.6 mm.

The metallic mesh plate of the the ring-shaped electrode 20 has a folded edge 23 proximal with respect to the first end.

In this way the portion of the metallic mesh plate that faces the cable conductor is rounded, thus avoiding electric charge accumulation on a tip portion.

The at least one protrusion may have, at its free end, a threaded bush 24 made of conducting material.

The termination assembly according to the present disclosure comprises an electric field control element 50 (even called stress member) intended to be fitted to a power cable and an insulator 10 intended to be coupled to the electric field control element so as to surround it at least partially. In particular, the electric field control element 50 comprises a deflector 52 made of semiconductive material and an insulating body 53 at least partially surrounding the deflector 52.

In the assembled configuration the electric field control element 50 results to be compressed between the power cable 30 and the main body 11 of the insulator 10. This compression may be obtained through a spring element 51 wound over the electric field control element 50.

Such a termination assembly may make part of the GIS termination, like for example the one illustrated in figure 6, which also comprises a tubular casing 60 adapted to be fixed to the insulator 10 and to house the insulator 10 and a bare conductor 70 configured to be installed within the tubular casing 60 and to be electrically connected to the electric conductor 31 of the power cable. The tubular casing can be a metallic tubular casing, for example a steel tubular casing, set at ground potential during operation.

In particular, the tubular casing 60 may be fixed to a flange 61 provided at the second longitudinal end 13 of the insulator through screws 62 or other fixing means. The space between the tubular casing 60 and the insulator 10 may be filled with insulating gas, like for example sulfur hexafluoride or SF6 gas. Furthermore, the bare conductor 70 is intended to be electrically connected on one side to the electric conductor 31 of the power cable 30 and on the other side to electric equipments (not illustrated) outside of the GIS termination, such as power transformer, over-head medium or high voltage lines, etc.

The insulator 10 may comprise a metallic insert 14 configured to be electrically connected to the electric conductor 31 of the power cable 30 on one side and to the bare conductor 70 on the other side. In other words the metallic insert 14 is aimed at making the electrical connection between the power cable 30 and the bare conductor 70. In the illustrated embodiment, the metallic insert 14 is provided with a plug element 71 intended to be fixed to the electric conductor 31 of the power cable 30. In this particular embodiment, the metallic insert 14 includes an housing configured for receiving the plug element 71 and the metallic insert 14 is electrically connected to the electric conductor 31 of the power cable 30 through the plug element 71. The termination assembly, according to the present disclosure, may make part also of an outdoor termination of the fluid-filled type or of the dry type as illustrated in figures 7 and 8 respectively.

In particular, the fluid-filled type outdoor termination, as it can be observed in figure 7, comprises also a tubular casing 80 made of insulating material adapted to house the insulator 10 and a bare conductor 70 configured to be installed within the tubular casing 80 and to be electrically connected to the electric conductor 31 of the power cable.

The tubular casing 80 may be fixed to a flange 61 provided at the second longitudinal end 13 of the insulator through screws 62 or other fixing means. The space between the tubular casing 80 and the insulator may be filled with a fluid, for example silicon oil, or SF6 gas, or with a gel, for example silicon gel, or with a foam, for example polyurethane foam.

In the illustrated embodiment, the insulator 10 comprises a metallic insert 14 configured to be electrically connected to the electric conductor 31 of the power cable 30 on one side and to the bare conductor 70 on the other side. In figure 7, the metallic insert 14 is provided with a plug element 71 intended to be fixed to the electric conductor 31 of the power cable 30. The metallic insert 14 includes an housing configured for receiving the plug element 71 and the metallic insert 14 is electrically connected to the electric conductor 31 of the power cable 30 through the plug element 71.

The dry type outdoor termination, as it can be observed in figure 8, comprises also a bare conductor 70 configured to be installed within the insulator 10 and to be electrically connected to the electric conductor 31 of the power cable. The insulator 10 comprises a metallic insert 14 configured to be electrically connected to the electric conductor 31 of the power cable 30 on one side and to the bare conductor 70 on the other side. In figure 8, the metallic insert 14 is provided with a plug element 71a, 71b intended to be fixed to the electric conductor 31 of the power cable 30. The metallic insert 14 includes an housing configured for receiving the plug element 71 and the metallic insert 14 is electrically connected to the electric conductor 31 of the power cable 30 through the plug element 71.The cable termination system 100, according to the present disclosure, comprise the power cable 30 and the termination (GIS or outdoor) coupled to the power cable 30. In particular, the electric control field element 50 is fitted to the power cable 30, the insulator 10 is coupled to the electric field control element 50 so as to surround it at least partially.

## Claims

1. Insulator (10) for a cable termination assembly comprising:
- a main body (11) of insulating material extending along a longitudinal direction X and having a cylindrically symmetrical shape with a first longitudinal end (12) and a second longitudinal end (13) opposite to each other, said main body (11) being adapted to be fitted on a power cable;
- a ring-shaped electrode (20) made of a mesh of conducting material integrated in the main body (11) at a predefined distance from the first end (12), said ring-shaped electrode (20) being configured to be connected to an external voltage detector.

2. Insulator (10) according to claim 1 wherein said ring-shaped electrode (20) is provided of at least one protrusion (21) made of conducting material and extending from the ring-shaped electrode (20) to an outer surface of the main body (11).

3. Insulator (10) according to claim 1 or 2 of the previous claims wherein the at least one protrusion (21) has, at its free end, a threaded bush (24) made of conducting material.

4. Insulator (10) according to to one or more of the previous claims wherein the ring-shaped electrode (20) comprises a metallic mesh plate (22) shaped as a ring.

5. Insulator (10) according to one or more of the previous claims wherein the ring-shaped electrode (20) has a folded edge (23) proximal with respect to the first end (12).

6. Insulator (10) according to one or more of the previous claims wherein the mesh of conducting material has a cover factor comprised between 0.2 and 0.5.

7. Insulator (10) according to one or more of the preceding claims wherein the main body (11) is made of epoxy resin.

8. Insulator (10) according to claim 7 comprising a metallic insert (14) configured to be electrically connected to an exposed electric conductor of the power cable on one side and to a bare conductor on the other side.

9. A termination assembly for a power cable (30) comprising:
- an electric field control element (50) intended to be fitted to the power cable (30);
- an insulator (10) according to one or more of the previous claims wherein said insulator (10) is intended to be coupled to the electric field control element (50) so as to surround it at least partially.

10. A Gas Insulated Substations termination comprising:
- a termination assembly according to claim 8;
- a tubular casing (60) adapted to be fixed to the insulator and to house the insulator (10)
- a bar conductor (70) configured to be installed within the tubular casing and to be electrically connected to an electric conductor (31) of a power cable (30).

11. Cable termination system (100) comprising:
- a power cable (30);
- an electric field control element (50) fitted to the power cable (30);
- an insulator (10) according to one or more of the claims 1-8 wherein said insulator (10) is coupled to the electric field control element (50) so as to surround it at least partially.

12. Cable termination system (100) according to claim 11 wherein the ring-shaped electrode (20) and the cable electric conductor (31) are electrically insulated with each other thus realizing a first capacitor, and wherein a voltage detector (40) is electrically connected to the ring-shaped electrode (20), the voltage detector (40) including a second capacitor connected in series with the first capacitor.

13. Cable termination system (100) according to claim 11 wherein the ring-shaped electrode (20) and the cable electric conductor are electrically insulated with each other thus realizing a first capacitor, the insulator (10) including a second capacitor connected in series to the first capacitor and wherein a voltage detector (40) is electrically connected to the second capacitor.

14. Cable termination system (100) according claim 12 or 13 wherein the voltage detector is configured to detect if the cable electric conductor (31) is under voltage and/or the presence of partial discharges on the cable or on the cable termination system.

15. Method for monitoring a cable termination assembly comprising:
- connecting the ring-shaped electrode (20) of an insulator (10) for a cable termination assembly according to one or more of claims 1 to 8 applied on a power cable (30) to a voltage detector;
- detecting a voltage signal with the voltage detector (40) ;
- analyzing the voltage signal through the voltage detector (40) and determining if the cable is under voltage and/or detecting the presence of partial discharge.
